# EUROPEAN PATENT APPLICATION

(11) **EP 4 822 939 A1**
(43) Date of publication of application: **14.10.2026**
(21) Application number: 24900451.6
(22) Date of filing: 22.11.2024
(51) Int. Cl.: H02J 7/00, H02J 7/02, H02J 13/00

(54) **POWER STORAGE EQUIPMENT, DETERMINATION DEVICE, AND COMPUTER PROGRAM**

(30) Priority: 05.12.2023 JP 2023205634
(71) Applicant: GS Yuasa International Ltd., Kisshoin, Minami-ku, Kyoto-shi, Kyoto 601-8520 (JP)
(72) Inventor: MATSUDA Yuki, Kyoto-shi, Kyoto 601-8520 (JP); TAKAI Seiji, Kyoto-shi, Kyoto 601-8520 (JP)
(74) Representative: Grünecker Patent- und Rechtsanwälte PartG mbB
(86) International application number: PCT/JP2024/041370
(87) International publication number: WO 2025/121156

(57) **Abstract**

An energy storage facility includes: a plurality of energy storage devices that is connected in parallel; and a connection circuit that connects the plurality of energy storage devices to an external current supply source or current supply destination. The connection circuit includes a first current path that is connected to the current supply source or the current supply destination, a plurality of second current paths that is branched from the first current path and respectively connected to the plurality of energy storage devices, a first current sensor that measures a current flowing through the first current path, and a plurality of second current sensors that individually measures currents flowing through the plurality of respective second current paths. The energy storage facility includes a determination unit that determines whether or not there is an abnormality in the connection circuit using a measurement result of the first current sensor and measurement results of the plurality of second current sensors.

## Description

### TECHNICAL FIELD

The present disclosure relates to an energy storage facility, a determination device, and a computer program.

### BACKGROUND ART

Energy storage facilities that store electric power supplied from power generating facilities such as solar power generating facilities and wind power generating facilities, and supply the stored electric power to loads such as factories and office buildings as necessary have been widespread. An energy storage facility includes a large number of energy storage devices (energy storage modules or banks) mounted thereon.

### PRIOR ART DOCUMENT

### PATENT DOCUMENT

Patent Document 1: JP-A-2019-125482

### SUMMARY OF THE INVENTION

### PROBLEMS TO BE SOLVED BY THE INVENTION

Conventionally, when an abnormality occurs in an energy storage facility including a large number of energy storage devices, it is not easy to specify an abnormal location.

An object of the present disclosure is to provide an energy storage facility, a determination device, and a computer program that can determine an abnormality in a connection circuit that connects energy storage devices to a current supply source or a current supply destination.

### MEANS FOR SOLVING THE PROBLEMS

An energy storage facility according to the present disclosure includes: a plurality of energy storage devices that is connected in parallel; and a connection circuit that connects the plurality of energy storage devices to an external current supply source or current supply destination. The connection circuit includes a first current path that is connected to the current supply source or the current supply destination, a plurality of second current paths that is branched from the first current path and respectively connected to the plurality of energy storage devices, a first current sensor that measures a current flowing through the first current path, and a plurality of second current sensors that individually measures currents flowing through the plurality of respective second current paths. The energy storage facility includes a determination unit that determines whether or not there is an abnormality in the connection circuit using a measurement result of the first current sensor and measurement results of the plurality of second current sensors.

### ADVANTAGES OF THE INVENTION

According to the present disclosure, it is possible to determine an abnormality in a connection circuit that connects energy storage devices to a current supply source or a current supply destination.

### BRIEF DESCRIPTION OF THE DRAWINGS

Fig. 1 is a schematic view illustrating an overall configuration of an energy storage system including a storage battery facility (an example of an energy storage facility).
Fig. 2 is a schematic diagram illustrating an internal configuration of the storage battery facility.
Fig. 3 is an explanatory diagram for describing a circuit configuration of the storage battery facility.
Fig. 4 is a flowchart for describing a procedure of processing executed by the storage battery facility.
Fig. 5 is a block diagram for describing an internal configuration of a monitoring server.
Fig. 6 is a flowchart for describing a procedure of processing executed by the monitoring server.

### MODE FOR CARRYING OUT THE INVENTION

(1) An energy storage facility according to the present disclosure includes: a plurality of energy storage devices that is connected in parallel; and a connection circuit that connects the plurality of energy storage devices to an external current supply source or current supply destination. The connection circuit includes a first current path that is connected to the current supply source or the current supply destination, a plurality of second current paths that is branched from the first current path and respectively connected to the plurality of energy storage devices, a first current sensor that measures a current flowing through the first current path, and a plurality of second current sensors that individually measures currents flowing through the plurality of respective second current paths. The energy storage facility includes a determination unit that determines whether or not there is an abnormality in the connection circuit using a measurement result of the first current sensor and measurement results of the plurality of second current sensors.

The energy storage facility is a facility that is installed in parallel to a power generating facility such as a solar power generating facility or a wind power generating facility, stores electric power supplied from the power generating facility, and supplies the stored electric power to a load. An example of the energy storage facility is an Energy Storage System (ESS). Alternatively, the energy storage facility may be a power conditioner, a backup power supply device, or the like.

The energy storage facility includes a plurality of energy storage devices connected in parallel. The energy storage device is, for example, a module configured by connecting a plurality of energy storage cells in series, or a bank configured by connecting a plurality of the modules in series. In the following embodiments, a configuration of the energy storage facility including a plurality of the banks will be described.

It is important for the energy storage facility including the plurality of banks to be capable of correctly measuring the current of each bank. Accuracy of determination and estimation for an operation state, a deterioration state, and an expected operational life of the energy storage facility is affected by accuracy of measurement of the current of each bank. It is desired for the energy storage facility that is a social infrastructure to be constantly operating. It should be prevented that the operation of the energy storage facility is stopped by erroneous determination that an abnormality has occurred in a bank in a situation that there is actually no problem in the bank, due to a cause that the current measurement is not properly performed.

Since the energy storage facility such as the ESS includes a large number of banks, the number of current sensors included in each bank is also large, and there is a relatively high probability that an abnormality occurs in the current sensor in such a facility.

The energy storage facility in the above (1) determines whether or not there is an abnormality in the connection circuit using the measurement result of the first current sensor that measures the current flowing through the first current path and the measurement results of the plurality of second current sensors that individually measures the currents flowing through the plurality of second current paths, so that it is possible to determine whether there is an abnormality in the current path or there is an abnormality in the current sensor. Here, the abnormality in the current path refers to a state where a resistance of the current path increases due to some cause and a current of a magnitude that needs to originally flow through the current path no longer flows. The abnormality of the current sensor refers to a state where the current sensor no longer indicates a current value that needs to be originally indicated.

According to the configuration in the above (1), even when a current measurement value indicates an abnormal value, it is possible to determine a cause of the abnormal value and prevent the energy storage facility from stopping operating due to erroneous determination.

(2) In the energy storage facility described in the above (1), the determination unit may compare a current value indicating a magnitude of the current measured by the first current sensor, and a total value indicating a total of magnitudes of the individual currents measured by the plurality of second current sensors, compare a ratio of individual internal resistance values of the plurality of energy storage devices, and a ratio of the magnitudes of the individual currents measured by the plurality of second current sensors, and determine whether or not there is the abnormality in the connection circuit according to a comparison result between the current value and the total value and a comparison result between the ratio of the internal resistance values and the ratio of the magnitudes of the currents.

The energy storage facility in the above (2) can determine whether or not there is an abnormality in the connection circuit including the first current path, the plurality of second current paths, the first current sensor, and the plurality of second current sensors according to a comparison result between the current value of the current measured by the first current sensor and the total value of the currents measured by the second current sensor and a comparison result between the ratio of the internal resistance values and the ratio of the magnitudes of the currents flowing through the respective energy storage devices.

(3) In the energy storage facility described in the above (1) or (2), when the current value and the total value are different and the ratio of the internal resistance values and the ratio of the magnitudes of the currents are substantially equal, the determination unit may determine that there is an abnormality in the first current sensor.

When comparing the ratio of the internal resistance values and the ratio of the magnitudes of the currents flowing through the respective energy storage devices, and determining that the ratios are substantially equal, the energy storage facility in the above (3) can determine that there is no abnormality in the second current sensors that measure the currents flowing through the respective energy storage devices. Then, when the current value of the current measured by the first current sensor and the total value of the currents measured by the second current sensors are different, the energy storage facility can determine that there is an abnormality in the first current sensor.

Here, the expression "the ratio of the internal resistance values and the ratio of the magnitudes of the currents are substantially equal" has a meaning including a case where the ratios are completely equal and a case where the ratios deviate within a range of a tolerance compared to the case where the ratios are completely equal.

(4) In the energy storage facility described in any one of the above (1) to (3), when the current value and the total value are different and the ratio of the internal resistance values and the ratio of the magnitudes of the currents are different, the determination unit may determine that there is an abnormality in at least one of the second current sensors.

When the ratio of the internal resistance values and the ratio of the magnitudes of the currents flowing through the respective energy storage devices are different, there are both of a probability that there is an abnormality in any of the second current sensors and a probability that there is an abnormality in the second current path. In addition, the case where the current value of the current measured by the first current sensor and the total value of the currents measured by the second current sensors are different means that at least one of the second current sensors has not indicated the current value that needs to be originally indicated, so that the energy storage facility can determine that there is an abnormality in at least one of the second current sensors.

(5) In the energy storage facility described in any one of the above (1) to (4), when the current value and the total value are substantially equal and the ratio of the internal resistance values and the ratio of the magnitudes of the currents are different, the determination unit may determine that there is an abnormality in at least one of the second current paths.

When the ratio of the internal resistance values and the ratio of the magnitudes of the currents flowing through the respective energy storage devices are different, there are both of a probability that there is an abnormality in any of the second current sensors and a probability that there is an abnormality in the second current path. In addition, the case where the current value of the current measured by the first current sensor and the total value of the currents measured by the second current sensors are substantially equal means that there is no abnormality in the first current sensor and the second current sensors, so that the energy storage facility can determine that there is an abnormality in at least one of the second current paths.

Here, the sentence "the current value of the current measured by the first current sensor and the total value of the currents measured by the second current sensors are substantially equal" has a meaning including a case where the current value and the total value are completely equal and a case where the current value and the total value deviate within the range of the tolerance compared to the case where the current value and the total value are completely equal.

(6) In the energy storage facility described in any one of the above (1) to (5), when the current value and the total value are substantially equal and the ratio of the internal resistance values and the ratio of the magnitudes of the currents are substantially equal, the determination unit may determine that there is no abnormality in the connection circuit.

When the current value of the current measured by the first current sensor and the total value of the currents measured by the second current sensors are substantially equal, and the ratio of the internal resistance values and the ratio of the magnitudes of the currents flowing through respective energy storage devices are substantially equal, the energy storage facility in the above (6) can determine that there is no abnormality in the first current path, the plurality of second current paths, the first current sensor, and the plurality of second current sensors.

(7) In the energy storage facility described in any one of the above (1) to (6), the energy storage devices are each a module configured by connecting a plurality of energy storage cells in series or a bank configured by connecting a plurality of the modules in series.

According to the energy storage facility in the above (7), it is possible to avoid erroneous determination that the abnormality has occurred in the module or the bank in a situation that there is actually no problem in the module or the bank due to a cause that current measurement is not appropriately performed.

(8) A determination device according to the present disclosure includes: an acquisition unit that acquires a measurement result of a first current sensor and measurement results of a plurality of second current sensors from an energy storage facility including a plurality of energy storage devices connected in parallel, and a connection circuit including a first current path that is connected to an external current supply source or current supply destination, a plurality of second current paths that is branched from the first current path and respectively connected to the plurality of energy storage devices, the first current sensor that measures a current flowing through the first current path, and the plurality of second current sensors that individually measures currents flowing through the plurality of respective second current paths; and a determination unit that determines whether or not there is an abnormality in the connection circuit using the acquired measurement result of the first current sensor and the acquired measurement results of the plurality of second current sensors.

Even when a current measurement value indicates an abnormal value, the determination device in the above (8) can determine a cause of the abnormal value and prevent the energy storage facility from stopping operating due to erroneous determination.

(9) A computer program according to the present disclosure is a computer program for causing a computer to execute processing of:
acquiring a measurement result of a first current sensor and measurement results of a plurality of second current sensors from an energy storage facility including a plurality of energy storage devices connected in parallel,
and a connection circuit including a first current path that is connected to an external current supply source or current supply destination, a plurality of second current paths that is branched from the first current path and
respectively connected to the plurality of energy storage devices, the first current sensor that measures a current flowing through the first current path, and the plurality of second current sensors that individually measures currents flowing through the plurality of respective second current paths;
and determining whether or not there is an abnormality in the connection circuit using the acquired measurement result of the first current sensor and the acquired measurement results of the plurality of second current sensors.

Even when a current measurement value indicates an abnormal value, the computer program in the above (9) can determine a cause of the abnormal value and prevent the energy storage facility from stopping operating due to erroneous determination.

Hereinafter, the present invention will be specifically described with reference to the drawings illustrating the embodiments thereof.

### (First Embodiment)

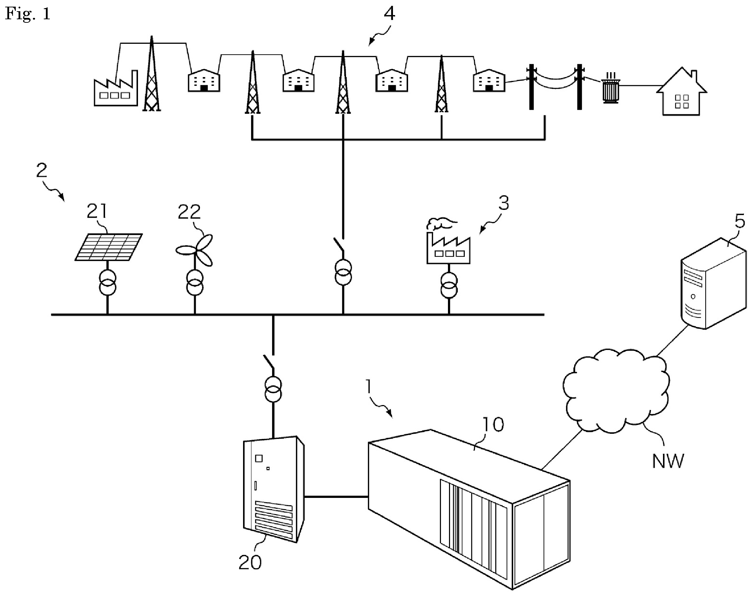

Fig. 1 is a schematic diagram illustrating an overall configuration of an energy storage system including a storage battery facility (an example of an energy storage facility). The energy storage system according to the embodiments includes a storage battery facility 1, a power generating facility 2, and a load 3. The storage battery facility 1 is, for example, an ESS, stores electric power supplied from the power generating facility 2, and supplies the stored electric power to the load 3. The power generating facility 2 includes a solar power generating facility 21, a wind power generating facility 22, and the like. The load 3 includes electric power consumption facilities such as factories, office buildings, schools, hospitals, restaurants, and airports.

An electric power converter 20 is installed between the storage battery facility 1 and the power generating facility 2, and the load 3. The electric power converter 20 is also referred to as a Power Conditioning System (PCS). The electric power converter 20 converts electric power (alternating-current electric power or direct-current electric power) supplied from the power generating facility 2 into direct-current electric power of a predetermined magnitude, and supplies the converted direct-current electric power to the storage battery facility 1. The storage battery facility 11 stores electric power supplied from the power generating facility 2 via the electric power converter 20.

The storage battery facility 11 supplies the stored electric power to the load 3 in response to a request from the outside. The electric power supplied from the storage battery facility 11 to the load 3 is converted from direct-current electric power to alternating-current electric power by the electric power converter 20.

Alternatively, the storage battery facility 11 may store the electric power supplied from an electric power system 4, or may supply the stored electric power to the electric power system 4.

The energy storage system includes a monitoring server 5 that remotely monitors the storage battery facility 1. The storage battery facility 1 and the monitoring server 5 are communicably connected via a communication network NW. The communication network NW may be a general line such as an Internet network or a dedicated line. The storage battery facility 1 transmits and receives information to and from the monitoring server 5 via the communication network NW.

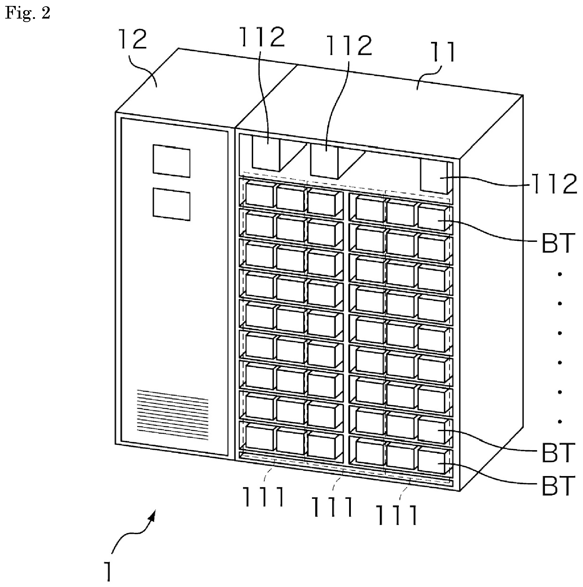

Fig. 2 is a schematic diagram illustrating an internal configuration of the storage battery facility 1. The storage battery facility 1 includes a container main body 10 (see Fig. 1), and a storage battery panel 11 and a control panel 12 housed in the container main body 10. Fig. 2 illustrates a configuration example of the storage battery panel 11 and the control panel 12 housed in the container main body 10. The number of the storage battery panels 11 included in the storage battery facility 1 may be two or more. The container main body 10 may house ancillary facilities such as an air conditioner and a lighting device in addition to the storage battery panel 11 and the control panel 12.

The storage battery panel 11 includes a plurality of banks 111 and a plurality of management units 112. Each bank 111 is configured by electrically connecting a plurality of energy storage modules BT in series. In the example in Fig. 2, the storage battery panel 11 includes the three banks 111, and each bank 111 is configured by electrically connecting the 18 energy storage modules BT in total in two rows in a vertical direction in series. These three banks 111 are connected in parallel to each other. The configuration in which the plurality of banks 111 is connected in parallel is also referred to as a domain. The number of the banks 111 included in the storage battery panel 11 and the number of the energy storage modules BT configuring each bank 111 are arbitrarily selected.

The energy storage module BT is configured by connecting a plurality of energy storage cells in series. In one example, the energy storage cell is a battery cell of a lithium ion secondary battery. Alternatively, the energy storage cell may be a battery cell of an all-solid-state battery, a lead-acid battery, a redox flow battery, a zinc-air battery, an alkaline manganese battery, a lithium sulfur battery, a sodium sulfur battery, a silver oxide-zinc battery, a nickel-metal hydride battery, a molten salt heat battery, or the like, or may be a capacitor. The number of energy storage cells configuring the energy storage module BT is arbitrarily selected.

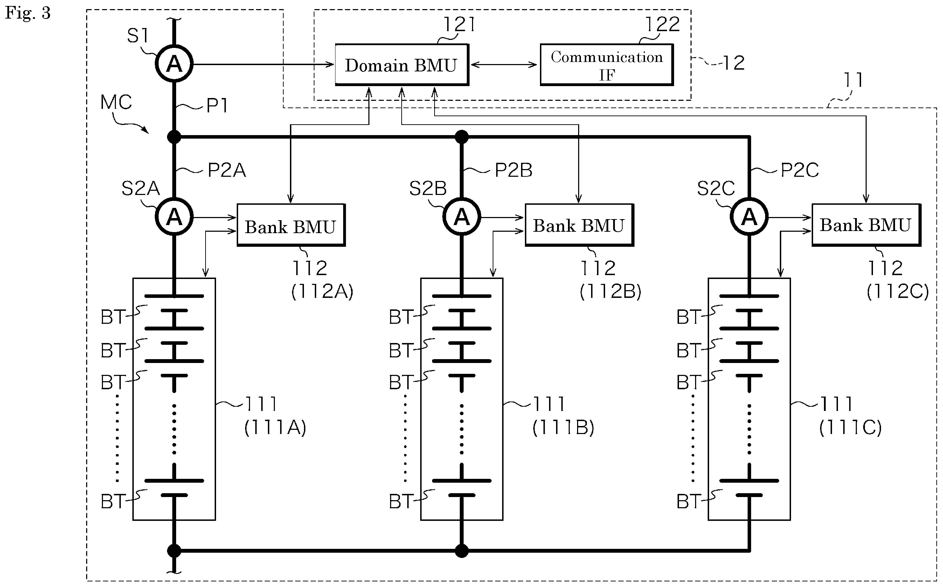

The management unit 112 is a device for monitoring the state of the bank 111. The management unit 112 is provided for each bank 111. In the example in Fig. 2, the management unit 112 is provided above each bank 111. Hereinafter, the management units 112 included in the storage battery panel 11 are referred to as the bank Battery Management Units (BMUs) 112. The bank BMU 112 monitors the state of the corresponding bank 111, and notifies an upper management unit (a domain BMU 121 illustrated in Fig. 3) of the obtained information of the bank 111.

Hereinafter, a configuration in which the storage battery facility 1 includes the one storage battery panel 11 and the storage battery panel 11 includes the three banks 111 will be described as an example.

Fig. 3 is an explanatory diagram for describing a circuit configuration of the storage battery facility 1. As described above, the storage battery panel 11 of the storage battery facility 1 includes the three banks 111 and the three bank BMUs 112 provided in association with the respective banks 111. The control panel 12 of the storage battery facility 1 includes the domain BMU 121 and a communication interface 122. The bank BMUs 112 and the domain BMU 121 are communicably connected. For communication between the bank BMUs 112 and the domain BMU 121, an existing communication standard such as a Controller Area Network (CAN) is used. Alternatively, communication standards such as the Local Interconnect Network (LIN), ECHONET (registered trademark), and ECHONETLight (registered trademark) may be used.

The bank 111 is connected to an external current supply source or current supply destination with a main circuit MC interposed therebetween. The external current supply source is the power generating facility 2 (or the electric power system 4), and the external current supply destination is the load 3 (or the electric power system 4).

In the following description, in a case where the three banks 111 are distinguished and described, the banks 111 will be also referred to as banks 111A, 111B, and 111C. Similarly, in a case where the three bank BMUs 112 are distinguished and described, the bank BMUs 112 will be also referred to as the bank BMUs 112A, 112B, and 112C.

The main circuit MC includes one first current path P1 connected to the current supply source or the current supply destination, and three second current paths P2A to P2C branched from the first current path P1 and connected to the banks 111A to 111C, respectively. The main circuit MC further includes a first current sensor S1 that measures the current flowing through the first current path P1, and three second current sensors S2A to S2C that measure the currents flowing through the respective second current paths P2A to P2C. The first current sensor S1 and the second current sensors S2A to S2C are existing current sensors such as Hall sensors. The first current sensor S1 outputs a measurement result to the domain BMU 121. The second current sensors S2A to S2C output the measurement results to the domain BMU 121 through the bank BMUs 112A to 112C.

The domain BMU 121 is a device for monitoring the state of the domain (the entire bank). The domain BMU 121 includes, for example, a Central Processing Unit (CPU), a Read Only Memory (ROM), a Random Access Memory (RAM), and the like. The CPU included in the domain BMU 121 causes the domain BMU 121 to function as a determination device according to the present application by reading and executing a computer program stored in the ROM. The RAM temporarily stores data generated during execution of the computer program and data acquired from the outside.

In the embodiment, the domain BMU 121 acquires a measurement result of the first current sensor S1 and measurement results of the second current sensors S2A to S2C, and determines whether or not there is an abnormality in a main circuit 120 using the acquired measurement result of the first current sensor S1 and measurement results of the second current sensors S2.

The domain BMU 121 outputs a determination result of whether or not there is the abnormality in the main circuit 120. For example, the domain BMU 121 provides a notification to an external device via the communication interface 122. An example of the external device is the monitoring server 5 that monitors the state of the storage battery facility 1. The communication interface 122 of the storage battery facility 1 and the monitoring server 5 are communicably connected via a communication network NWA such as the Internet. In a case where the storage battery facility 1 includes a display unit such as a liquid crystal display, the determination result of whether or not there is an abnormality in the main circuit 120 may be output to the display unit to cause the display unit to display the determination result.

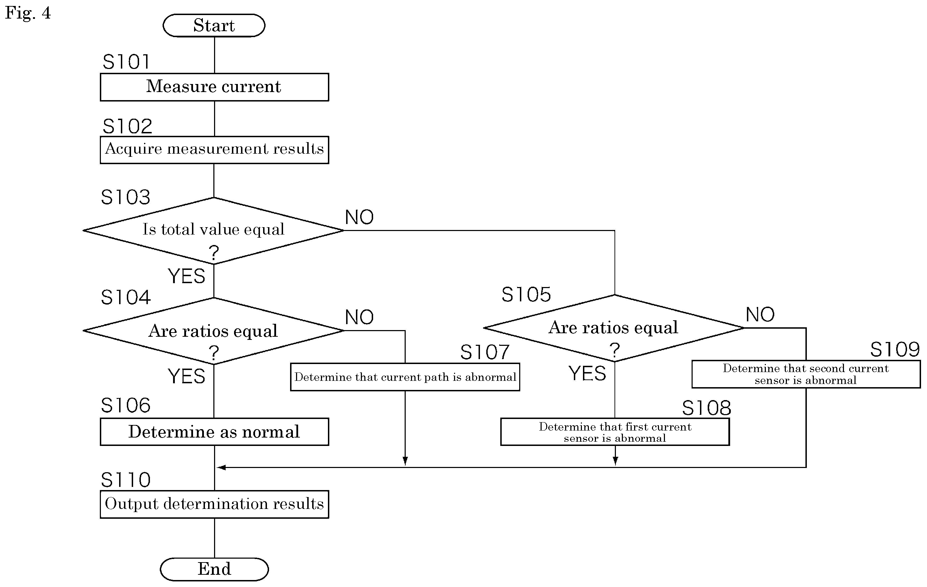

Fig. 4 is a flowchart for describing a procedure of processing executed by the storage battery facility 1. Upon execution of the following procedure, it is assumed that the internal resistance of each of the banks 111A to 111C is measured in advance. The internal resistance is obtained by actually measuring the voltage of each of the banks 111A to 111C at a time when constant current discharge is performed from each of the banks 111A to 111C. The voltage of each of the banks 111A to 111C is measured by an unillustrated voltage sensor. In a case where a current value at a time when constant current discharge is performed from the bank 111A is represented by I (I is known because constant current discharge is performed), and a voltage value of the bank 111A is represented by V (V represents an actual measurement value of a voltage sensor), an internal resistance R of the bank 111A is obtained by R = V/I. The same also applies to the internal resistances of the other banks 111B and 111C. The internal resistance values (Ra, Rb, and Rc, respectively) of the banks 111A, 111B, and 111C are obtained in advance, and each value is stored in the memory inside the domain BMU 121.

In the storage battery facility 1, when electric power is supplied to the load 3, the first current sensor S1 measures the current flowing through the first current path P1, and the second current sensors S2A to S2C measure the respective currents flowing through the respective second current paths P2A to P2C (step S101). The measurement result of the current sensor S1 is output to the domain BMU 121. The measurement results of the current sensors S2A to S2C are respectively output to the bank BMUs 112A to 112C.

The domain BMU 121 acquires the measurement result of the first current sensor S1, and acquires the measurement results of the second current sensors S2A to S2C through the bank BMUs 112A to 112C (step S102). A current value obtained as the measurement result of the first current sensor S1 is represented by I, and current values obtained as the measurement results of the second current sensors S2A, S2B, and S2C are respectively represented by Ia, Ib, and Ic.

The domain BMU 121 compares the current value measured by the first current sensor S1 and a total value of the current values Ia to Ic measured by the second current sensors S2A to S2C, and determines whether or not the current value and the total value are equal (step S103). That is, the domain BMU 121 determines whether or not I = Ia+Ib+Ic holds. The current value and the total value do not need to completely match numerically, and values thereof may deviate within a range of a tolerance. In this case, in a case where the tolerance is represented by ε1, if a difference between the current value and the total value is less than ε1, it is determined that the current value and the total value are substantially equal. The tolerance ε1 is set as appropriate. For example, the tolerance ε1 may be artificially set. Alternatively, a difference (= |I-(Ia+Ib+Ic)|) between the current values may be actually measured using the normal connection circuit MC, and a tolerance ε based on the difference may be set.

When determining that the total value of the currents is equal (S103: YES), the domain BMU 121 compares a ratio (= Ra:Rb:Rc) of the internal resistance values of the banks 111A to 111C and a ratio (= Ia:Ib:Ic) of the current values measured by the second current sensors S2A to S2C, and determines whether or not the ratios are equal (step S104). That is, the domain BMU 121 determines whether or not Ra:Rb:Rc = Ia:Ib:Ic holds. The ratios do not need to completely match numerically, and values thereof may deviate within a range of a tolerance. For example, in a case of tolerances ε2 and ε3, if |Ia/Ra-Ib/Rb| < ε2 and |Ia/Ra-Ic/Rc| < ε3 hold, it is determined that the ratios are substantially equal. The tolerances ε2 and ε3 are set as appropriate. For example, ε2 and ε3 may be artificially set. Alternatively, the ratio (Ia:Ib:Ic) may be actually measured using the normal connection circuit MC, and the tolerances ε2 and ε3 based on this ratio may be set.

When the total value of the currents is equal (S103: YES) and the ratios are equal (S104: YES), the domain BMU 121 determines that the current paths (the first current path P1 and the second current paths P2A to P2C) and the current sensors (the first current sensor S1 and the second current sensors S2A to S2C) in the connection circuit MC are normal (step S106).

When determining that the total value of the currents is equal (S103: YES) and the ratios are different (S104: NO), the domain BMU 121 determines that the first current sensor S1 and the second current sensors S2A to S2C are normal and there is an abnormality in any one of the second current paths P2A to P2C (step S107). When determining that there is an abnormality in any one of the second current paths P2A to P2C, the domain BMU 121 may specify in which current path there is an abnormality. In the embodiments, the ratio of the internal resistance values is known, so that the domain BMU 121 can specify a path through which a current assumed from the ratio of the internal resistance values does not flow as a path having an abnormality.

When determining in step S103 that the total value of the currents is different (S103: NO), the domain BMU 121 compares the ratio (= Ra:Rb:Rc) of the internal resistance values of the respective banks 111A to 111C and the ratio (= Ia:Ib:Ic) of the current values measured by the second current sensors S2A to S2C, and determines whether or not the ratios are equal (step S105). A determination method is similar to that in step S104, and the domain BMU 121 determines whether or not Ra:Rb:Rc = Ia:Ib:Ic holds. The ratios do not need to completely match numerically, and values thereof may deviate within a range of a tolerance.

When determining that the total value of the currents is different (S103: NO) and the ratios are equal (S105: YES), the domain BMU 121 determines that the first current sensor S1 is abnormal (step S108).

When determining that the total value of the currents is different (S103: NO) and the ratios are different (S105: NO), the domain BMU 121 determines that any one of the second current sensors S2A to S2C is abnormal (step S109).

The domain BMU 121 outputs the determination results in S106 to S109 (step S110). For example, the domain BMU 121 notifies the monitoring server 5 of the determination results via the communication interface 122. In a case where the control panel 12 includes a display unit such as a liquid crystal display, the domain BMU 121 may display the determination results on the display unit.

As described above, in the first embodiment, by using the measurement result of the current flowing through the first current path P1 and the measurement results of the currents flowing through the respective second current paths P2A to P2C, it is possible to determine in which one of the first current path P1, the second current paths P2A to P2C, the first current sensor S1, and the second current sensors S2A to S2C configuring the main circuit MC there is an abnormality.

### (Second Embodiment)

In the second embodiment, a configuration where the monitoring server 5 executes determination processing will be described.

Since the overall configuration of the energy storage system and the internal configuration of the storage battery facility 1 are similar to those of the first embodiment, description thereof will be omitted.

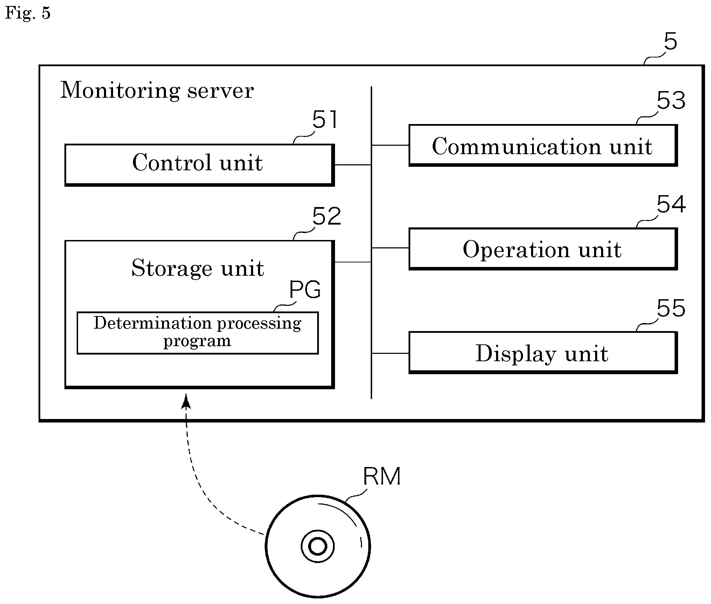

Fig. 5 is a block diagram for describing an internal configuration of the monitoring server 5. The monitoring server 5 includes a control unit 51, a storage unit 52, a communication unit 53, an operation unit 54, a display unit 55, and the like.

The control unit 51 is, for example, an arithmetic circuit including a CPU, a ROM, a RAM, and the like. The CPU included in the control unit 51 reads and executes various computer programs stored in the ROM and the storage unit 52 to function as the determination device that determines an abnormality in the main circuit MC in the storage battery facility 1. In the embodiments, the control unit 51 determines the abnormality in the main circuit MC based on measurement results obtained from the storage battery facility 1.

Alternatively, the control unit 51 may be an arbitrary arithmetic circuit including a plurality of CPUs, a multi-core CPU, a Graphics Processing Unit (GPU), a microcomputer, a volatile or nonvolatile memory, and the like. The control unit 51 may have functions such as a timer that measures an elapsed time from a time at which a measurement start instruction is given to a time at which a measurement end instruction is given, a counter that counts numbers, and a clock that outputs date and time information.

The storage unit 52 includes a storage device such as a flash memory or a hard disk. The storage unit 52 stores various computer programs and data. The computer programs stored in the storage unit 52 include a determination processing program PG for causing the computer to execute processing of determining an abnormality in the main circuit MC based on the measurement results acquired from the storage battery facility 1. The data stored in the storage unit 52 includes parameters used for the determination processing program PG, data generated by the control unit 51, and the like.

The computer program including the diagnostic program PG is provided with a non-transitory recording medium RM in which the computer programs have been readably recorded. The recording medium RM is a portable memory such as a CD-ROM, a USB memory, or a Secure Digital (SD) card. The control unit 51 reads a desired computer program from the recording medium RM using an unillustrated reading device, and causes the storage unit 52 to store the read computer program. Alternatively, the computer programs including the determination processing program PG may be provided by communication.

The communication unit 53 includes a communication interface that transmits and receives various types of information. The communication unit 53 receives, for example, the measurement results of the first current sensor S1 and the second current sensors S2A to S2C transmitted by the storage battery facility 5.

The operation unit 54 includes input devices such as various switches and buttons, and accepts an operation of an administrator. The display unit 55 includes a display device such as a liquid crystal display device, and displays information that needs to be broadcast to the administrator. Alternatively, the monitoring server 5 may be configured to accept a necessary operation through an external computer, and transmit, to the external computer, information that needs to be notified to the administrator. In this case, the operation unit 54 and the display unit 55 may not be mounted on the monitoring server 5.

In the embodiments, the monitoring server 5 may be a single computer or may be a computer system including a plurality of computers, peripheral devices, and the like. The monitoring server 5 may be a virtual machine whose entity has been virtualized or may be a cloud.

In the embodiments, the determination processing program PG may be a single computer program or may be a program group including a plurality of computer programs. The determination processing program PG may be executed by a plurality of computers in cooperation.

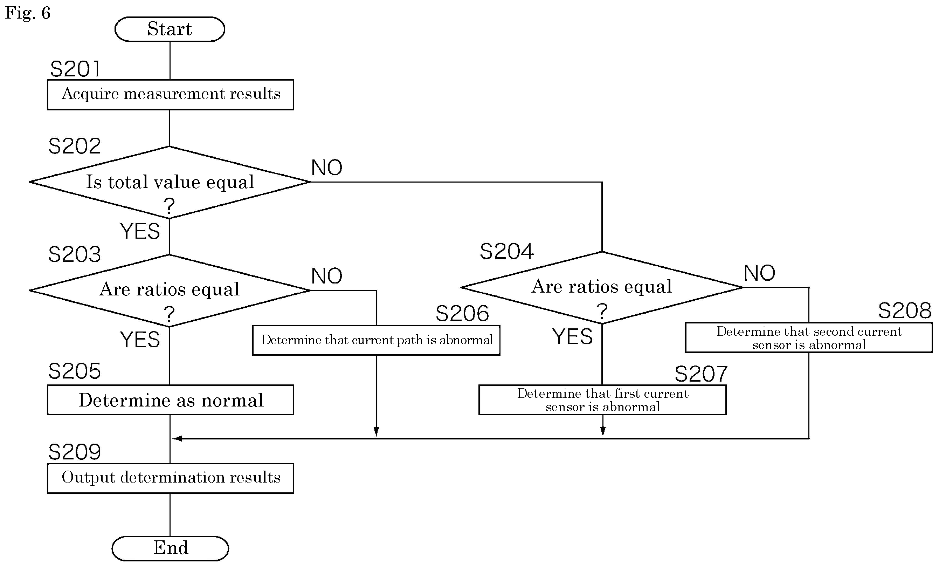

Fig. 6 is a flowchart for describing a procedure of processing executed by the monitoring server 5. Upon execution of the following procedure, it is assumed that the internal resistance of each of the banks 111A to 111C is measured in advance, and each measured value is stored in the storage unit 52 of the monitoring server 5.

The control unit 51 of the monitoring server 5 acquires the measurement result of the first current sensor S1 and the measurement results of the second current sensors S2A to S2C from the storage battery facility 1 through the communication unit 53 (step S201).

The control unit 51 determines an abnormality in the main circuit MC using the acquired measurement results. A determination procedure is similar to that in the first embodiment. The control unit 51 compares the current value measured by the first current sensor S1 and the total value of the currents measured by the second current sensors S2A to S2C, and determines whether or not the current value and the total value are equal (step S202). The control unit 51 compares the ratio of the internal resistance values of the respective banks 111A to 111C and the ratio of the current values measured by the second current sensors S2A to S2C, and determines whether or not the ratios are equal (steps S203 and 204).

When determining that the total value is equal and the ratios are equal (S202: YES and S203: YES), the control unit 51 determines that the main circuit MC is normal (step S205).

When determining that the total value is equal and the ratios are different (S202: YES and S203: NO), the control unit 51 determines that there is an abnormality in any one of the second current paths P2A to P2C (step S206).

When determining that the total value is different and the ratios are equal (S202: NO and S204: YES), the control unit 51 determines that there is an abnormality in the first current sensor S1 (step S207).

When the total value is different and the ratios are different (S202: NO and S204: NO), the control unit 51 determines that there is an abnormality in any one of the second current sensors S2A to S2C (step S208).

The control unit 51 outputs the determination results in S205 to S208 (step S209). For example, the control unit 51 may display the determination results on the display unit 55. Alternatively, the control unit 51 may notify a terminal of the administrator or the like of the determination results via the communication unit 53.

As described above, in the second embodiment, the external monitoring server 5 can determine in which one of the first current path P1, the second current paths P2A to P2C, the first current sensor S1, and the second current sensors S2A to S2C configuring the main circuit MC of the storage battery facility 1 there is an abnormality.

The disclosed embodiments are illustrative in all respects and are not restrictive. The scope of the present invention is defined by the claims, and includes meanings equivalent to the claims and all changes within the scope.

For example, the embodiments employ the configuration where the storage battery facility 1 includes the one storage battery panel 11, and this storage battery panel 11 includes the three banks 111. Alternatively, there may be employed a configuration where the storage battery facility 1 includes the plurality of storage battery panels 11, and each storage battery panel includes the one or more banks 111.

The embodiments have employed the configurations including the electric power converter 20 separately from the storage battery facility 1. Alternatively, there may be employed a configuration where the storage battery facility 1 includes the electric power converter 20.

### DESCRIPTION OF REFERENCE SIGNS

1: Storage battery facility (energy storage facility)
2: Power generating facility
3: Load
4: Electric power system
5: Monitoring server
11: Storage battery panel
12: Control panel
111: Bank
112: Bank BMU
121: Domain BMU
122: Communication interface
MC: Connection circuit
P1: First current path
P2A to P2C: Second current path
S1: First current sensor
S2A to S2C: Second current sensor

## Claims

1. An energy storage facility comprising:
a plurality of energy storage devices that is connected in parallel; and
a connection circuit that connects the plurality of energy storage devices to an external current supply source or current supply destination, wherein
the connection circuit includes
a first current path that is connected to the current supply source or the current supply destination,
a plurality of second current paths that is branched from the first current path and respectively connected to the plurality of energy storage devices,
a first current sensor that measures a current flowing through the first current path, and
a plurality of second current sensors that individually measures currents flowing through the plurality of respective second current paths, and
the energy storage facility comprises a determination unit that determines whether or not there is an abnormality in the connection circuit using a measurement result of the first current sensor and measurement results of the plurality of second current sensors.

2. The energy storage facility according to claim 1, wherein
the determination unit
compares a current value indicating a magnitude of the current measured by the first current sensor, and a total value indicating a total of magnitudes of the individual currents measured by the plurality of second current sensors,
compares a ratio of individual internal resistance values of the plurality of energy storage devices, and a ratio of the magnitudes of the individual currents measured by the plurality of second current sensors, and
determines whether or not there is the abnormality in the connection circuit according to a comparison result between the current value and the total value and a comparison result between the ratio of the internal resistance values and the ratio of the magnitudes of the currents.

3. The energy storage facility according to claim 2, wherein
when the current value and the total value are different and the ratio of the internal resistance values and the ratio of the magnitudes of the currents are substantially equal, the determination unit determines that there is an abnormality in the first current sensor.

4. The energy storage facility according to claim 2, wherein
when the current value and the total value are different and the ratio of the internal resistance values and the ratio of the magnitudes of the currents are different, the determination unit determines that there is an abnormality in at least one of the second current sensors.

5. The energy storage facility according to claim 2, wherein
when the current value and the total value are substantially equal and the ratio of the internal resistance values and the ratio of the magnitudes of the currents are different, the determination unit determines that there is an abnormality in at least one of the second current paths.

6. The energy storage facility according to claim 2, wherein
when the current value and the total value are substantially equal and the ratio of the internal resistance values and the ratio of the magnitudes of the currents are substantially equal, the determination unit determines that there is no abnormality in the connection circuit.

7. The energy storage facility according to any one of claims 1 to 6, wherein the energy storage devices are each a module configured by connecting a plurality of energy storage cells in series or a bank configured by connecting a plurality of the modules in series.

8. The energy storage facility according to any one of claims 1 to 7, further comprising a display unit that displays the determination results from the determination unit.

9. The energy storage facility according to any one of claims 1 to 7, further comprising a communication unit that notifies an administrator or the like of the determination results from the determination unit.

10. A determination device comprising:
an acquisition unit that acquires a measurement result of a first current sensor and measurement results of a plurality of second current sensors from an energy storage facility including a plurality of energy storage devices connected in parallel, and a connection circuit including a first current path that is connected to an external current supply source or current supply destination, a plurality of second current paths that is branched from the first current path and respectively connected to the plurality of energy storage devices, the first current sensor that measures a current flowing through the first current path, and the plurality of second current sensors that individually measures currents flowing through the plurality of respective second current paths; and
a determination unit that determines whether or not there is an abnormality in the connection circuit using the acquired measurement result of the first current sensor and the acquired measurement results of the plurality of second current sensors.

11. A computer program for causing a computer to execute processing of:
acquiring a measurement result of a first current sensor and measurement results of a plurality of second current sensors from an energy storage facility including a plurality of energy storage devices connected in parallel, and a connection circuit including a first current path that is connected to an external current supply source or current supply destination, a plurality of second current paths that is branched from the first current path and respectively connected to the plurality of energy storage devices, the first current sensor that measures a current flowing through the first current path, and the plurality of second current sensors that individually measures currents flowing through the plurality of respective second current paths; and
determining whether or not there is an abnormality in the connection circuit using the acquired measurement result of the first current sensor and the acquired measurement results of the plurality of second current sensors.

12. A determination method comprising:
acquiring a measurement result of a first current sensor and measurement results of a plurality of second current sensors from an energy storage facility including a plurality of energy storage devices connected in parallel, and a connection circuit including a first current path that is connected to an external current supply source or current supply destination, a plurality of second current paths that is branched from the first current path and respectively connected to the plurality of energy storage devices, the first current sensor that measures a current flowing through the first current path, and the plurality of second current sensors that individually measures currents flowing through the plurality of respective second current paths; and
determining whether or not there is an abnormality in the connection circuit using the acquired measurement result of the first current sensor and the acquired measurement results of the plurality of second current sensors.

13. A determination method comprising:
acquiring a measurement result of a first current sensor and measurement results of a plurality of second current sensors from an energy storage facility including a plurality of energy storage devices connected in parallel, and a connection circuit including a first current path that is connected to an external current supply source or current supply destination, a plurality of second current paths that is branched from the first current path and respectively connected to the plurality of energy storage devices, the first current sensor that measures a current flowing through the first current path, and the plurality of second current sensors that individually measures currents flowing through the plurality of respective second current paths;
determining whether or not there is an abnormality in the connection circuit using the acquired measurement result of the first current sensor and the acquired measurement results of the plurality of second current sensors; and
displaying the determination results.

14. A determination method comprising:
acquiring a measurement result of a first current sensor and measurement results of a plurality of second current sensors from an energy storage facility including a plurality of energy storage devices connected in parallel, and a connection circuit including a first current path that is connected to an external current supply source or current supply destination, a plurality of second current paths that is branched from the first current path and respectively connected to the plurality of energy storage devices, the first current sensor that measures a current flowing through the first current path, and the plurality of second current sensors that individually measures currents flowing through the plurality of respective second current paths;
determining whether or not there is an abnormality in the connection circuit using the acquired measurement result of the first current sensor and the acquired measurement results of the plurality of second current sensors; and
notifying a terminal of an administrator or the like of the determination results.
